# EUROPEAN PATENT APPLICATION

(11) **EP 4 535 967 A1**
(43) Date of publication of application: **09.04.2025**
(21) Application number: 23202239.2
(22) Date of filing: 06.10.2023
(51) Int. Cl.: H10K 30/57, H10K 71/12, H10K 85/50

(54) **WIDE BANDGAP PEROVSKITE**

(71) Applicant: TOYOTA JIDOSHA KABUSHIKI KAISHA, Toyota-shi, Aichi-ken, 471-8571 (JP)
(72) Inventor: KINGE, Sachin, 1140 Brussels (BE); ZHANG, Yi, 1015 Lausanne (CH); NAZEERUDDIN, Mohammad Khaja, 1015 Lausanne (CH); DYSON, Paul Joseph, 1015 Lausanne (CH)
(74) Representative: Cabinet Beau de Loménie

(57) **Abstract**

A method for making a wide bandgap perovskite includes: preparing a solvent (102) by mixing 4 volumes of DMF and 1 volume of DMSO; preparing a first solution (104) of AM Cs_{0.3}FA_{0.7}Pb(I_{(1-y)}Br_{y})₃ with the solvent; preparing a second solution (106) of AM IH₃NCH₂CH₂NH₃PbI₃ with the solvent; preparing a third solution (108) of AM MAPbCl₃ with the solvent; preparing a fourth solution (110) with 0.97^{∗}(100-B) vol% of the first solution, 0.97*B vol% of the second solution and 3 vol% of the third solution, wherein 2 ≤ B ≤ 22; depositing a film (112) of the fourth solution on a substrate with an anti-solvent; annealing the deposited film (114) in inert atmosphere at temperature below 110°C to obtain the wide bandgap perovskite.

## Description

### BACKGROUND OF THE INVENTION

### 1. Field of the Invention

The invention notably relates to a method for making a wide bandgap perovskite for solar cell, an associated wide bandgap perovskite and a perovskite tandem device for solar cell comprising this wide bandgap perovskite.

### 2. Description of Related Art

Metal Halide perovskite solar cells have recently emerged as high-efficiency and low-cost thin-film photovoltaic technology with 25.7% power conversion efficiency (PCE). The high-power conversion efficiencies and stabilities over 1000 hours at 85°C under 1 Sun illumination have been obtained using lab scale processes and small cell areas. The building blocks of the perovskite materials are very low cost, and the processing into the final perovskite can be achieved with low-temperature fast processes. This makes these materials cost-efficient, enabling the potential to achieve a levelised cost of electricity (LCOE) estimated in different locations and the values range from 0.03 to 0.05 $/kWh, below that of today's mainstream photovoltaic (PV) technologies.

Although these achievements are impressive, the use of more stable structure towards solar cells commercially available still needs to be demonstrated to make perovskite solar cells a real alternative to the existing Si-based technology.

Metal halide perovskite absorbers consist of an ABX₃ formula. The B-cation is coordinated octahedrally by X-anions, and the A-cation fills the cuboctahedral voids and compensates for the negative charge, where X generally is Cl, Br, or I, the A-site is either inorganic cation Cs+ or organic cations, such as CH₃NH₃⁺ (MA) and NH₂CH=NH₂⁺ (FA), the B-site is either Pb²⁺ or Sn²⁺ (or a combination of them).

Typically, for perovskite/perovskite tandem devices, narrow-bandgap perovskites are prepared by Sn-Pb hybrids, which have a bandgap of about 1.25 eV, could be perfectly matched with the easily prepared wide-bandgap perovskite of 1.78 eV

However, the narrow bandgap device of Pb-Sn is not stable due to Sn²⁺ oxidation to Sn⁴⁺.

Therefore, for narrow bandgap it is better to use stable pure lead perovskites.

But the difficulty is that the optimal wide bandgap (WBG) perovskites should have bandgap at about 1.86 eV to pair with low bandgap perovskites (≈1.46 eV) in Pb/Pb perovskite tandems so that they can reach the theoretical maximum power conversion efficiency (PCE), which needs to be mixed with more Br⁻. However, usually, 30% Br content is the limit to maintain stability (the bandgap is about 1.8 eV). If this value is exceeded, the stability and efficiency of WBG perovskite solar cells (PSCs) are constrained by the light-induced halide segregation resulting in the large photovoltage deficit.

### SUMMARY OF THE INVENTION

The present disclosure relates to a method for making a wide bandgap perovskite for solar cell, the method including:
- preparing a solvent by mixing 4 volumes of DMF (dimethylformamide) and 1 volume of DMSO (dimethyl sulfoxide);
- preparing a first solution of AM Cs_{0.3}FA_{0.7}Pb(I_{(1-y)}Br_{y})₃ with the solvent, wherein FA designates NH₂CH=NH₂⁺ and wherein 1.00 ≤ A ≤ 1.55 and 0.2 ≤ y ≤ 0.4;
- preparing a second solution of A M IH₃NCH₂CH₂NH₃PbI₃ with the solvent;
- preparing a third solution of A M methylammonium lead chloride noted MAPbCl₃ with the solvent;
- preparing a fourth solution with 0.97*(100-B) vol% of the first solution, 0.97*B vol% of the second solution and the additional 3 vol% of the third solution, wherein 2 ≤ B ≤ 22;
- depositing a film of the fourth solution on a substrate with an anti-solvent; and
- annealing the deposited film in inert atmosphere at temperature below 110°C to obtain the wide bandgap perovskite.

The method allows for preparing a high-quality and photostable WBG perovskites (1.85 eV) suitable for Pb/Pb perovskite tandems.

By alloying IH₃NCH₂CH₂NH₃I and Cl⁻ into the mixed-cation mixed-halide perovskites, a wide bandgap perovskite absorber is obtained with lower bromide contents while the lattice strain and trap densities are simultaneously minimized.

Moreover, the dissolution of large cations makes the properties of perovskite gradually change from three-dimensional (3D) to two-dimensional (2D), which is more stable. Two-dimensional perovskite is obtained by compensating the large cations with Cs⁻ to maintain a consistent average tolerance factor. The local distortions in the lattice parameters allowing increase of the lattice micro-strain and modification of the optoelectronic properties of the perovskite. The selection of values for y, A and B is the result of a comprehensive compromise between the band gap and crystal structure of the finished perovskite, which together determine the efficiency of the device.

After assembly into a tandem, the stability of the device as a whole is greatly improved due to the more stable wide bandgap perovskite first exposure to harmful light and heat.

In addition, the stable and high-efficiency WBG perovskite may be incorporated in perovskite/silicon 2-terminal and 4-terminal configurations.

Also, another high-efficiency thin film technology CIGS (Copper Indium Gallium Selenide) may be used to replace silicon bottom cells.

In some embodiments, 0.25 ≤ y ≤ 0.35, for example y = 0.3.

In some embodiments, 1.15 ≤ A ≤ 1.25, for example A = 1.20.

In some embodiments, 10 ≤ B ≤ 20, for example B = 15.

The anti-solvent allows removing DMF and DMSO during the preparation process of the wide bandgap perovskite. The anti-solvent may be chosen among: diethyl ether, chlorobenzene, toluene, or a mixture of these compounds. Diethyl ether has the best effect.

The present disclosure also relates to a wide bandgap perovskite for solar cell including IH₃NCH₂CH₂NH₃I at content between 10 and 20 mol%. This wide bandgap perovskite can be obtained by carrying the above described method.

The present disclosure also relates to a method for fabricating a perovskite tandem device for solar cell, wherein the wide band gap perovskite is obtained by the above-described method.

The method for fabricating the perovskite tandem device includes:
- preparing a patterned transparent conducting oxide glass substrate, e.g. a transparent conducting ITO (indium tin oxide) glass substrate or a transparent conducting FTO (fluorine doped tin oxide) glass substrate; this preparation step may comprise a cleaning of the patterned transparent conducting oxide glass substrate;
- depositing a first hole transporting material layer on the prepared patterned transparent conducting oxide glass substrate;
- depositing the wide bandgap perovskite layer by the above-described method on the first hole transporting material layer;
- depositing a first electron transport layer on the wide bandgap perovskite layer;
- depositing a transparent ITO layer on the first electron transport layer;
- depositing a second hole transporting material layer on the transparent ITO layer;
- depositing a narrow bandgap perovskite layer on the second hole transporting material layer;
- depositing a second electron transport layer on the narrow bandgap perovskite layer;
- depositing a counter electrode on the second electron transport layer.

The narrow bandgap perovskite layer has a bandgap lying in the range 1.46 eV to 1.59 eV.

The present disclosure also relates to a perovskite tandem device including the above-described wide bandgap perovskite.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 shows the PCE as a function of the bandgap of the front subcell and the back subcell in a tandem device;
FIG. 2 shows a flow chart of a method for making a wide bandgap perovskite for solar cell according to an embodiment of the invention;
FIG. 3 shows a flow chart of a method for fabricating a perovskite tandem device for solar cell according to an embodiment of the invention;
FIG. 4 shows a schematic representation of a tandem device for solar cell according to an embodiment of the invention;
FIG. 5 shows a micrograph of a tandem device for solar cell according to the non-limiting example described below;
FIG. 6 shows a graph of the absorbance (in arbitrary units) as a function of the wavelength (in nm) showing the effect of both IH₃NCH₂CH₂NH₃I and Cl⁻ into the mixed-cation mixed-halide perovskites;
FIG. 7 shows a graph of the current density (in mA.cm⁻²) as a function of the voltage (in V) showing the effect of both IH₃NCH₂CH₂NH₃I and Cl⁻ into the mixed-cation mixed-halide perovskites;
FIG. 8 shows a graph of the External Quantum Efficiency (EQE, in %) as a function of the wavelength (in nm) for the wide bandgap perovskite (plain circles) and the narrow bandgap perovskite (plain squares) of the non-limiting example; and
FIG. 9 shows a graph of the current density (in mA.cm⁻²) as a function of the voltage (in V) for the tandem device of the non-limiting example and for a traditional single device.

### DETAILED DESCRIPTION OF EMBODIMENTS

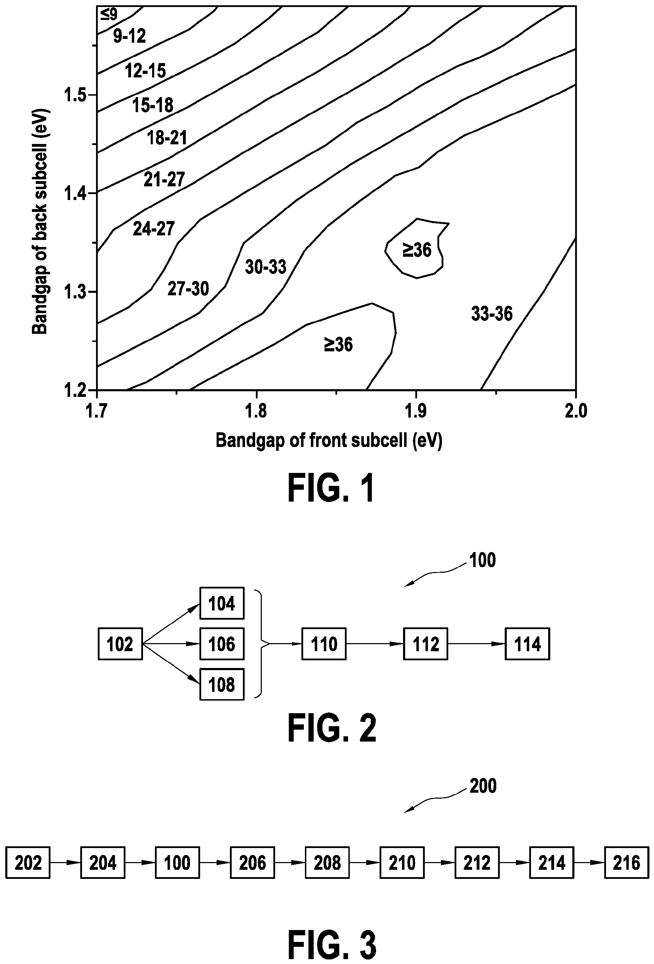

As shown in FIG. 1, the bandgap of mixed-cation mixed-halide lead perovskites can be tuned between 1.2 and 2.0 eV by varying the type and content of ABX₃, which providing the possibility for the fabrication of tandem devices by perovskite/perovskite.

FIG.2 shows a flow chart of a method 100 for making a wide bandgap perovskite for solar cell.

The method 100 includes a step of preparing a solvent 102 by mixing 4 volumes of DMF and 1 volume of DMSO.

The method 100 includes a step of preparing a first solution 104 of AM Cs_{0.3}FA_{0.7}Pb(I_{(1-y)}Br_{y})₃ with the solvent, wherein 1.00 ≤ A ≤ 1.55, for example 1.15 ≤ A ≤ 1.25, and 0.2 ≤ y ≤ 0.4, for example 0.25 ≤ y ≤ 0.35.

The method 100 includes a step of preparing a second solution 106 of A M IH₃NCH₂CH₂NH₃Pbl₃ with the solvent.

The method 100 includes a step of preparing a third solution 108 of AM MAPbCl₃ with the solvent.

The method 100 includes a step of preparing a fourth solution 110 with 0.97*(100-B) vol% of the first solution, 0.97*B vol% of the second solution and 3 vol% of the third solution, wherein 2 ≤ B ≤ 22, for example 10 ≤ B ≤ 20.

The method 100 includes a step of depositing a film 112 of the fourth solution on a substrate with diethyl ether, chlorobenzene, toluene, or a mixture of these compounds.

The method 100 includes a step of annealing the deposited film 114 in inert atmosphere at temperature below 110°C to obtain the wide bandgap perovskite. The annealing step may comprise applying a first temperature lying in the range 55°C to 75°C during a first duration lying in the range 2 minutes to 4 minutes, and then applying a second temperature lying in the range 90°C to 105°C during a second duration lying in the range 10 minutes to 15 minutes.

### Non-limiting example

A = 1.2;
B = 15; and
y = 0.3.

The step of preparing the first solution 104 of 1.2 M Cs_{0.3}FA_{0.7}Pb(I_{(1-y)}Br_{y})₃ with the solvent may be carried out by mixing 0.36 mmol CsBr, 0.36 mmol PbBr₂, 0.84 mmol FAI and 0.84 mmol PbI₂ into 1 ml solvent.

The step of preparing the second solution 106 of 1.2 M IH₃NCH₂CH₂NH₃PbI₃ with the solvent may be carried out by mixing 1.2 mmol IH₃NCH₂CH₂NH₃I and 1.2 mmol PbI₂ into 1 ml solvent.

The step of preparing the third solution 108 may be carried out by mixing 1.2 mmol MACl and 1.2 mmol PbCl₂ into 1 ml solvent.

The step of preparing the fourth solution 110 may be carried out by mixing 0.97*85 vol% of the first solution, 0.97*15 vol% of the second solution and 3 vol% of the third solution. As a non-limiting example, the first and second solutions may first be mixed together and the third solution may then be added to the mix of the first and the second solutions.

The step of depositing a film 112 of the fourth solution on a substrate with diethyl ether may be carried out by spin-coating, for example at 5000 rpm for 60 s with 750 µL diethyl ether dripped at 25 s during the spinning.

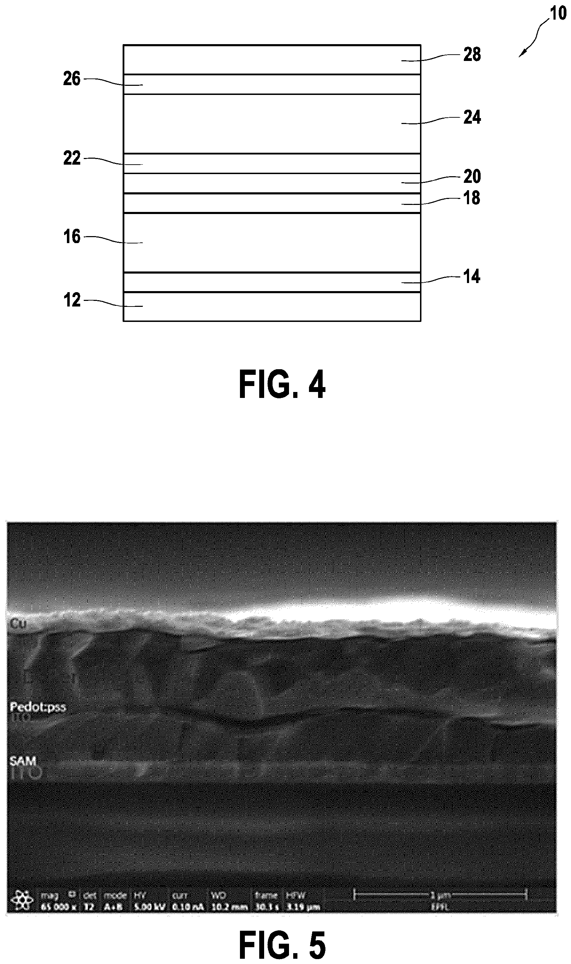

The step of annealing the deposited film 114 may be carried out in inert atmosphere at temperature below 110°C to obtain the wide bandgap perovskite. It may be carried out at 65°C for 2 minutes and then 100°C for 10 minutes in nitrogen (N₂). FIG. 3 shows a flow chart of a method 200 for fabricating a perovskite tandem device for solar cell including a wide bandgap perovskite obtained by the method 100 for making a wide bandgap perovskite for solar cell described above and FIGS. 4 and 5 respectively show a schematic representation of a tandem device for solar cell and a micrograph of a tandem device for solar cell fabricated by the method 200 for fabricating a perovskite tandem device for solar cell. It is to be noted that FIG. 4 is not to scale.

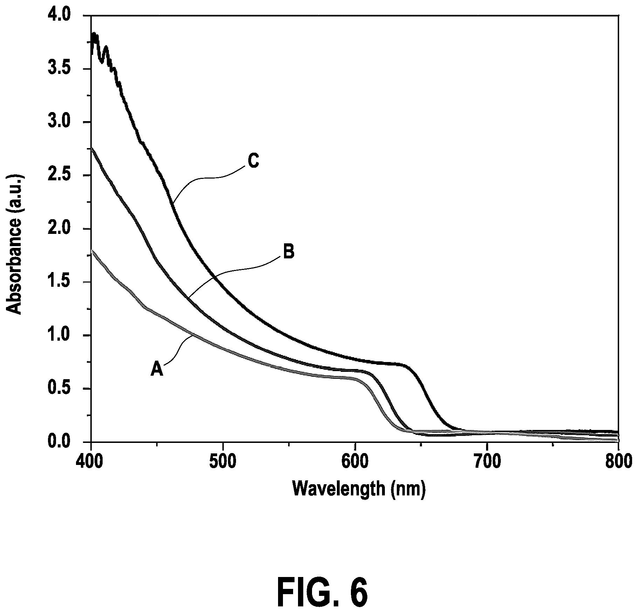

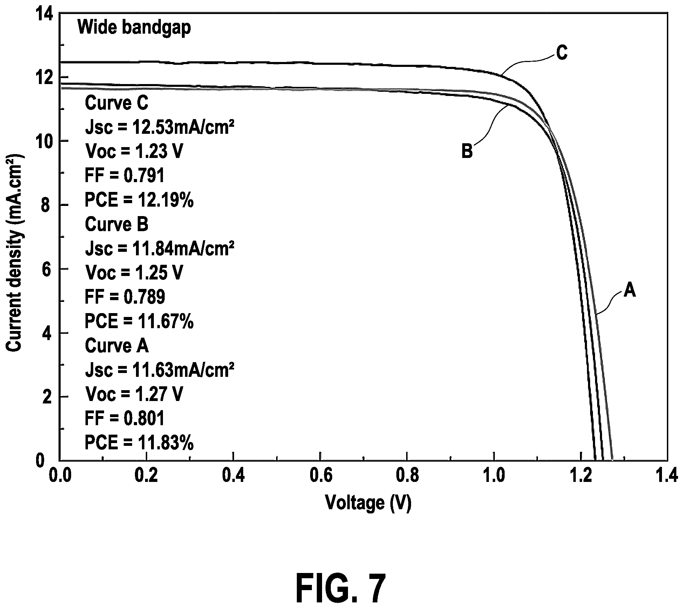

FIG. 6 shows a graph of the absorbance in arbitrary unit as a function of the wavelength in nm and FIG. 7 shows a graph of the current density in mA.cm⁻² as a function of the voltage in V. Both graphs show the effect of both IH₃NCH₂CH₂NH₃I and Cl⁻ into the mixed-cation mixed-halide perovskite. In these graphs, the curves labelled "A" correspond to the non-limiting example of the invention described above, the curves labelled "B" are outside the scope of the invention and correspond to this non-limiting example wherein the third solution has been omitted (only first and second solutions), and the curves labelled "C" are outside the scope of the invention and correspond to the use of the first and third solutions only (second solution omitted).

The method 200 includes known-steps for making a tandem device 10.

The method 200 includes a step 202 of preparing a patterned transparent conducting oxide glass substrate 12.

As non-limiting examples, the patterned transparent conducting oxide glass substrate 12 may be made of a glass substrate coated with indium tin oxide (ITO) or fluorine doped tin oxide (FTO).

The method 200 includes a step 204 of depositing a first hole transporting material (HTM) layer 14 on the prepared patterned transparent conducting oxide glass substrate 12.

The method 200 includes a step of depositing a wide bandgap perovskite layer 16 by the above-described method 100 on the first hole transporting material layer 14.

The method 200 includes a step 206 of depositing a first electron transport layer (ETL) 18 on the wide bandgap perovskite layer 16.

The method 200 includes a step 208 of depositing a transparent conducting oxide glass layer 20 on the first electron transport layer 18.

The method 200 includes a step 210 of depositing a second hole transporting material (HTM) layer 22 on the transparent conducting oxide glass layer 20.

The method 200 includes a step 212 of depositing a narrow bandgap perovskite layer 24 on the second hole transporting material layer 22.

The method 200 includes a step 214 of depositing a second electron transport layer 26 on the narrow bandgap perovskite layer 24.

The method 200 includes a step 216 of depositing a counter electrode 28 on the second electron transport layer 26.

### Non-limiting example

Patterned transparent conducting oxide glass substrate: In₂O₃/SnO₂ 90/10 wt% on a glass substrate.

First hole transporting material: MeO-2PACZ forming self-assembled monolayers (SAM) which form uniform coverage on top of oxide surface providing efficient extraction of positive charges.

Wide bandgap perovskite layer: 1.85 eV perovskite obtained by method 100.

First electron transport layer: C₆₀.

Transparent conducting oxide glass layer: In₂O₃/SnO₂ 90/10 wt%.

Second hole transporting material layer: PEDOT:PSS.

Narrow bandgap perovskite layer: 1.47 eV 1.5 M Rb_{0.05}Cs_{0.05}MA_{0.05}FA_{0.85}Pb(I_{0.95}Br_{0.05})₃.

Second electron transport layer: C₆₀.

Counter electrode: Cu.

The step 202 of preparing the patterned transparent ITO glass substrate may be carried out by washing the ITO glass substrate with acetone and isopropanol for 15 min each. This substrate may correspond to commercial ITO glass that has been laser etched.

The step 204 of depositing the first HTM layer on the prepared ITO substrate may be carried out by treating with ultraviolet ozone for 15 min the prepared ITO substrate and by spin-coating a 0.5 mg/ml MeO-2PACZ self-assembled monolayer solution dissolved in ethanol on the prepared ITO substrate at 3000 rpm for 30 s in a nitrogen glovebox. The spin-coated film was then annealed at 100°C for 10 min.

The step of depositing the wide bandgap perovskite layer may be carried out by the above-described method 100 on the first HTM layer.

As non-limiting example, the fourth solution may be deposited on the first HTM layer with diethyl ether by spin-coating, for example at 5000 rpm for 60 s with 750 µL diethyl ether dripped at 25 s during the spinning. The deposited film may be annealed in inert atmosphere at temperature below 110°C to obtain the wide bandgap perovskite. The annealing step may be carried out at 65°C for 2 min and then 100°C for 10 minutes in nitrogen (N₂).

The step 206 of depositing the first ETL on the wide bandgap perovskite layer may be carried out by transferring the sample to an Angstrom evaporator for LiF (1 nm)/C₆₀ (30 nm) deposition.

The transparent conducting oxide layer may be deposited onto the first ETL (step 208) by transferring the sample to a sputtering system and sputtering about 120 nm of ITO layer having a sheet resistance of around 30 Ω sq⁻¹ from a 3 inch target at 100 W power under Ar pressure of 1.5 mtorr.

The sheet resistance of the ITO layer was measured by using four-point probe method while the ITO layer was deposited on a glass substrate.

The step 210 of depositing a second HTM layer on the transparent conducting oxide glass layer may be carried out by spin-coating a solution of PEDOT:PSS at 3000 rpm for 30 s in a nitrogen glovebox and post-annealing the spin-coated solution at 110°C for 5 min.

The step 212 of depositing a narrow bandgap perovskite layer on the second HTM layer may be carried out by preparing a 1.5 M Rb_{0.05}Cs_{0.05}MA_{0.05}FA_{0.85}Pb(I_{0.95}Br_{0.05})₃ precursor solution in the solvent, the respective chemical molar ratio of CsI, RbI, FAI, PbI₂, PbBr₂ and MABr being 0.05, 0.05, 0.85, 0.95, 0.05 and 0.05.

The precursor solution was spin-coated onto the sample, the sample first spinning at 1000 rpm (within 1 s from 0 to 1000; no slow acceleration step) for 10 s, and then at 3000 rpm (no slow acceleration) for 40 s. After 15 s into the second stage (3000 rpm, 40 s), 150 µL of chlorobenzene antisolvent was dropped on top of the spinning sample. The perovskite layer was subsequently annealed at 100°C for 10 min.

The step 214 of depositing the second ETL on the narrow bandgap perovskite layer may be carried out by transferring the sample to an Angstrom evaporator for LiF (1 nm)/C₆₀ (30 nm)/BCP (6 nm)/Ag (100 nm) deposition.

The step 216 of depositing the copper counter electrode on the second electron transport layer may be carried out by vacuum evaporation method.

Methylammonium iodide (MAI), methylammonium bromide (MAI), methylammonium chloride (MACl), ethane-1,2-diammonium iodide (IH₃NCH₂CH₂NH₃I) and formamidinium iodide (FAI) were purchased from the GreatCell Solar Company. Lead bromide (99.999%) and MeO-2PACZ was purchased from Tokyo Chemical Industry Co. Lead iodide (PbI₂, 99.9985%), Rubidium iodide (RbI, 99.9%), caesium iodide (CsI, 99.9%) and diethyl ether were purchased from Alfa Aesar., N,N-dimethylmethanamide (DMF) (anhydrous), Lead chloride (PbCl₂), dimethyl sulfoxide (DMSO) (anhydrous), tetrakis(dimethylamino) tin (iv) (99.9999%) and chlorobenzene (CB) were purchased from Aldrich Sigma. Poly(3,4-ethylenedioxythiophene):polystyrene sulfonate (PEDOT:PSS, CLEVIOS P VP AI 4083) was purchased from Heraeus, LLC. Bathocuproine (BCP) were purchased from Jilin OLED Company (China). Indium tin oxide (ITO, In₂O₃/SnO₂ 90/10 wt%) target and silver (Ag) were purchased from Kurt J. Lesker Company. All chemicals used in this work were commercially available and were used as received.

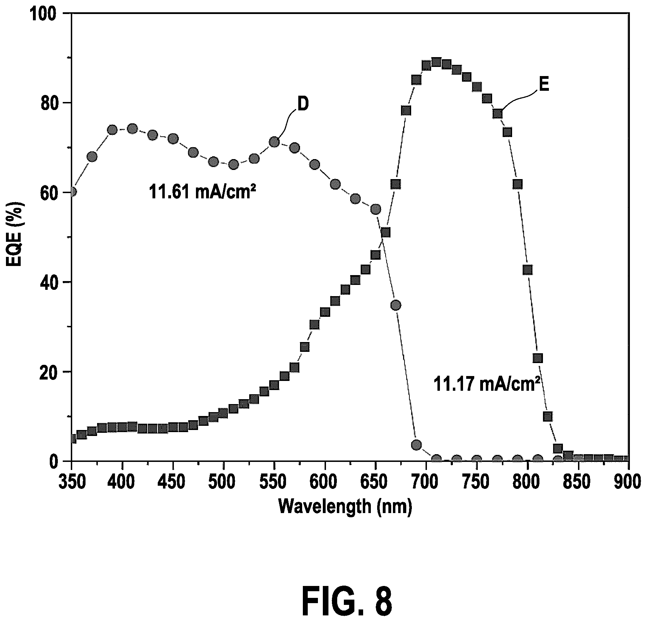

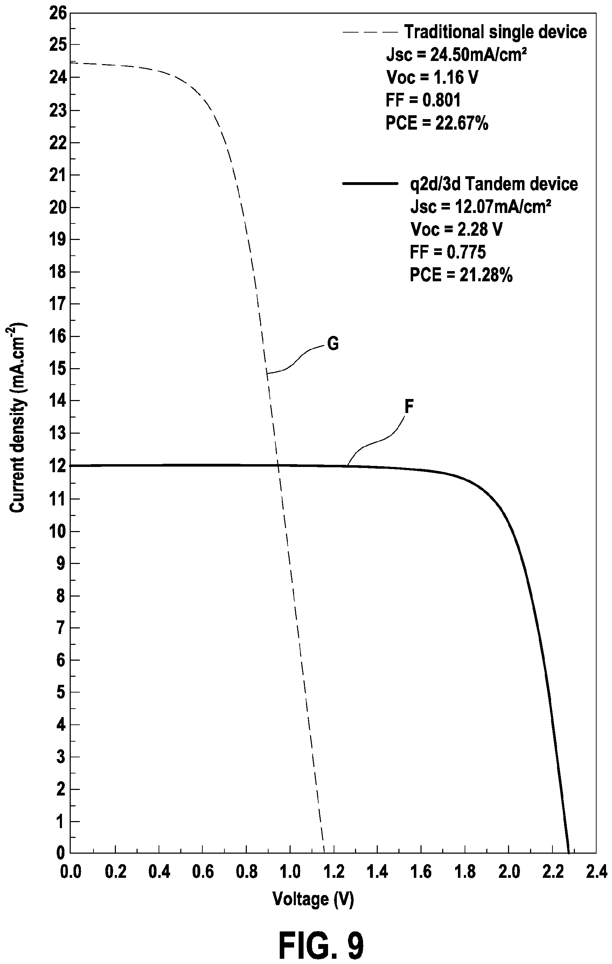

FIG. 8 shows a graph of the External Quantum Efficiency (in %) as a function of the wavelength (in nm) for the wide bandgap perovskite (plain circles, curve "D") and the narrow bandgap perovskite (plain squares, curve "E") of the non-limiting example and FIG. 9 shows a graph of the current density (in mA.cm⁻²) as a function of the voltage (in V) for the tandem device of the non-limiting example (curve "F") compared to a traditional single device (curve "G").

As shown in FIG 9, the single junction solar cells exhibit 1.0 to 1.2 V open circuit potential. The tandem device shows double the voltage of single junction solar cell. The tandem device exhibited the characteristic of doubling the voltage and halving the current, with a fill factor (FF) of 0.775, and showed a consistent PCE (21.28%).

Moreover, in principle, adding more Br should make the perovskite absorber more stable, given the strength of the lead (Pb)-Br bond relative to the Pb-I bond.

Combined with enhanced stable two-dimensional phase formation, the wide bandgap perovskite that is first exposed to harmful factors such as UV and heat can better protect the narrow bandgap perovskite bottom cell, thereby improving the overall stability of 2T tandem devices

Current-voltage characteristics were recorded by applying an external potential bias to the cell while recording the generated photocurrent with a digital source meter (Keithley Model 2400). The light source was a 450 W xenon lamp (Oriel) equipped with a SchottK113 Tempax sunlight filter (Praezisions Glas & Optik GmbH) to match the emission spectrum of the lamp to the AM1.5G standard. Before each measurement, the exact light intensity was determined using a calibrated Si reference diode equipped with an infrared cutoff filter (KG-3, Schott). The cells were masked with the active area of 0.09 cm² to fix the active area and reduce the influence of the scattered light for the small device.

IPCE spectra were recorded as functions of wavelength under a constant white light bias of ≈10 mW·cm⁻² supplied by an array of white light emitting diodes. The excitation beam coming from a 300 W xenon lamp (ILC Technology) was focused through a Gemini-180 double monochromator (Jobin Yvon Ltd) and chopped at ≈2 Hz. The signal was recorded using a Model SR830 DSP Lock-In Amplifier (Stanford Research Systems).

The SEM of film morphology was investigated by using a high-resolution scanning electron microscope (Merlin, Zeiss) equipped with a GEMINI II column and a Schottky Field Emission gun. Images were acquired with an In-Lens Secondary Electron Detector. XRD was performed using a D8 Advance diffractometer (Bruker AXS) model in an angular range of 2θ = 5°- 40° or 10°-15° (Bruker Corporation, Billerica, MA, USA).

The absorption spectra have been registered with a UV-VIS-IR spectrophotometer (PerkinElmer Instrument).

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

## Claims

1. A method (100) for making a wide bandgap perovskite for solar cell, the method comprising:
- preparing a solvent (102) by mixing 4 volumes of DMF and 1 volume of DMSO;
- preparing a first solution (104) of AM Cs_{0.3}FA_{0.7}Pb(I_{(1-y)}Br_{y})₃ with the solvent, wherein FA designates NH₂CH=NH₂⁺ and wherein 1.00 ≤ A ≤ 1.55 and 0.2 ≤ y ≤ 0.4;
- preparing a second solution (106) of A M IH₃NCH₂CH₂NH₃Pbl₃ with the solvent;
- preparing a third solution (108) of A M methylammonium lead chloride noted MAPbCl₃ with the solvent;
- preparing a fourth solution (110) with 0.97*(100-B) vol% of the first solution, 0.97*B vol% of the second solution and 3 vol% of the third solution, wherein 2 ≤ B ≤ 22;
- depositing a film (112) of the fourth solution on a substrate with an anti-solvent; and
- annealing the deposited film (114) in inert atmosphere at temperature below 110°C to obtain the wide bandgap perovskite.

2. The method (100) of claim 1, wherein 0.25 ≤ y ≤ 0.35.

3. The method (100) of claim 1 or 2, wherein 1.15 ≤ A ≤ 1.25.

4. The method (100) of any one of claims 1 to 3, wherein 10 ≤ B ≤ 20.

5. The method (100) of any one of claims 1 to 4, wherein the anti-solvent is diethyl ether, chlorobenzene, toluene, or a mixture of these compounds.

6. The method (100) of claim 5, wherein the anti-solvent is diethyl ether.

7. A wide bandgap perovskite for solar cell comprising IH₃NCH₂CH₂NH₃I at content between 10 and 20 mol%.

8. A method (200) for fabricating a perovskite tandem device for solar cell, wherein the wide band gap perovskite is obtained by the method (100) of any one of claims 1 to 6.

9. A perovskite tandem device for solar cell comprising the wide bandgap perovskite of claim 7.
